(19) Europäisches Patentamt / European Patent Office / Office européen des brevets

(11) **EP 3 093 968 A1**

(12) **EUROPEAN PATENT APPLICATION**

(43) Date of publication:
**16.11.2016 Bulletin 2016/46**

(51) Int Cl.:
*H02M 3/156* (2006.01)　　　*H02M 3/157* (2006.01)

(21) Application number: **15167853.9**

(22) Date of filing: **15.05.2015**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**MA**

(71) Applicant: **Zentrum Mikroelektronik Dresden AG 01109 Dresden (DE)**

(72) Inventors:
• **Meola, Marco**
 **80638 München (DE)**
• **Kelly, Anthony**
 **Co. Limerick (IE)**

(74) Representative: **Lippert, Stachow & Partner Patentanwälte**
 **Krenkelstrasse 3**
 **01309 Dresden (DE)**

(54) **METHOD FOR TUNING A PARAMETER OF AN ELECTRONIC DEVICE**

(57)　The present invention relates to a method for tuning a parameter of an electronic device. The method comprises: measuring a tuning variable x; translating said measured tuning variable into a tuning range out of a plurality of tuning ranges representing a piece-wise tuning function. The piece-wise tuning function represents a tuning variable to parameter value mapping. Each tuning range i is associated with a nominal parameter value $M_i$. The method further comprises determining a parameter value M within said tuning range and setting the parameter to the determined parameter value.

## Fig. 11

Application/
Datasheed View
Resistor #1 to #16

Electronic Device -
internal View
Trip Level #0 to #15

$V_{TL\#2}$

$V_{meas}$

Resistor #3

$V_{Mi}$　$V_{meas} - V_{Mi}$　$M_2$

$V_{TL\#1}$

$M = M_2 + f(V_{meas} - V_{Mi}) * \Delta M$

**Description**

FIELD OF THE INVENTION

The present invention relates to a method for tuning a parameter of an electronic as a function of a measured variable. The present invention specifically relates to a method for tuning a variable of a parameter of a power converter as a function of a measured variable

BACKGROUND OF THE INVENTION

In the development process of power modules, parameters of a DC-DC converter can be configured to meet application requirements and configuration data can be determined for a DC-DC converter serving a specific platform and the same configuration data can be used to configure all other converters serving the same platform. In this context, power modules manufactures are coming across the need to design power modules that are flexible to serve different platforms where operating parameters, such as input voltage, output voltage, nominal output current, transient performance etc. vary from platform to platform. To cut down development costs the POL DC-DC converter implemented in the power module is requested to have tunable parameters that can be easily accessed by the end-user without the need of fully reconfiguring the DC-DC converter.

Indeed, an electronic device can be preconfigured and a defined set of operating parameters may be adjusted directly in the application field by measuring a variable, generated internally or externally to the device, and selecting the value of a parameter out of a discrete set of values. To do that, the value of the parameter has to be uniquely identified by the value of the measured variable. Such measurement though is affected by errors both caused by tolerances of components used to generate the variable to be measured and errors introduced by the circuit used for the measurement.

The simplest variable to be measured is the measurement of voltage in a specific point of the electronic device. Such voltage may be generated by a trimmed current source flowing through a network of passive components such as resistors. Resistor tolerances as well as measurement errors limit the number of possible values of the parameter to be configured. Different methods can be implemented to reduce errors in the measurement.

US 4349777A discloses a method using resistors with very accurate values to generate an accurate voltage measurement. As well, the use of external resistors, although more inaccurate, for such purpose has the advantage of providing an easy selection of a parameter value to the end-user.

US 7292019B1 discloses a method to measure a voltage with the purpose of uniquely identifying the value of the parameter to be used. The method has the main disadvantages of allowing only a limited set of values to be associated to the parameter to configure and of not allowing tuning of the parameter around a preconfigured value. The method can be used to select the value of the set point of the DC-DC converter, as well as the timing for the ramp up of the DC-DC converter, i.e. soft turn on, and other converter parameters such as thresholds. Considering the example of configuring the set-point of the DC-DC converter, although the desired set point value can be selected via the method disclosed in US 7292019B1, voltage drops due to resistive components located in between the voltage sensing point and the applied load may lead to a lower set point value at the load side. This rises the need to fine tune the set point value to achieve the target value.

Together with the need of setting operating parameters of a DC-DC converter to serve different platforms, there is a need to be able to tailor the action of the compensator in case the external components defining the power stage of the DC-DC converter have changed. Indeed, a POL DC-DC converter may be designed to meet dynamic requirements of a specific platform that may be too week when compared to the requirement of other applications. The end-user may want to add additional bulk capacitance to overcome this problem, thus affecting stability of the regulation loop. Compensator parameters may need to be tuned accordingly to preserve stability and maintain the same dynamic behaviour of the regulated system.

DISCLOSURE OF THE INVENTION

A solution to the problems stated above is achieved by method according to the independent method claim. Dependent claims relate to further aspects of the present invention.

The present invention relates to a method for tuning a parameter of an electronic device. The method comprises: measuring a tuning variable x; translating said measured tuning variable into a tuning range out of a plurality of tuning ranges representing a piece-wise tuning function f(x). The piece-wise tuning function represents a tuning variable to parameter value mapping. Each tuning range i is associated with a nominal parameter value $M_i$. The method further comprises determining a parameter value M within said tuning range and setting the parameter to the determined parameter value.

Each tuning range i is defined around its respective nominal parameter value $M_i$ and is bounded by an upper bound and a lower bound. The size of the tuning range can be varied in dependence of a tuning range resolution $\Delta M$ which can be set and programmed to an internal memory of the electronic device. The parameter values of M are identified around each nominal parameter value $M_i$. Within each tuning range the tuning function f(x) is strictly monotone and thus bijective. Hence, each value of the tuning variable x corresponds to one and only one value of the parameter M to tune. Thus, the value of parameter M can be adjusted, within the tuning range, by acting on the tuning variable x. The tuning variable can be any measurable variable external to the electronic device whose measured value is used by the electronic device to tune the parameter M.

One aspect of the present invention relates to measuring the tuning variable which may comprise quantizing a measured tuning variable, e.g. an input voltage $V_{in}$ such as voltage $V_{pin}$ impinged upon a pin, using an analog-to-digital converter (ADC) having an ADC resolution $Q^{ADC}$; wherein a dynamic output range of the ADC is subdivided into a plurality of sub-ranges, each sub-range I $[V_{TL\#i-1} \ V_{TL\#i}]$ being associated with a respective nominal parameter value $M_i$ and being bounded by its upper bound $V_{TL\#i}$ and by its lower bound $V_{TL\#i-1}$.

One aspect of the present invention relates to the tuning variable to parameter mapping of the tuning function. The mapping comprises a mapping of nominal value of the tuning variable $V_{Mi}$ to the nominal parameter value $M_i$. Thus, the nominal value of the tuning variable $V_{Mi}$ can be set arbitrarily within the tuning range to produce asymmetric tuning ranges.

The mapping of the tuning function further comprises a mapping of a subrange $[V_{TL\#i-1} \ V_{TL\#i}]$ to a tuning range which may comprise a mapping of an ADC resolution $Q^{ADC}$ to the tuning range resolution $\Delta M$. In this way, the tuning resolution $\Delta M$ in connection with nominal parameter value $M_i$ indirectly defines the boundaries of the tuning range.

One aspect of the present invention relates to defining the tuning range. Defining the tuning range comprises setting an arbitrary value of the tuning variable within a subrange corresponding to the tuning range to a nominal value of the tuning variable $V_{Mi}$ such that it maps to the nominal parameter value $M_i$ using the tuning function, $M_i=f(V_{Mi})$, and setting the tuning resolution $\Delta M$.

A quantized measured tuning variable $V_{meas}$ falling into the subrange $[V_{TL\#i-1} \ V_{TL\#i}]$ of the ADC identifies the nominal parameter value $M_i$ associated with this subrange. Thus, $V_{meas}$ selects $M_i$ the nominal value for M. For a given resolution the parameter M to tune thus can assume values in the tuning range

$$\mathtt{M} \in [\mathtt{f}(\mathtt{V_{TL\#i-1}}) * \Delta\mathtt{M}, \ \mathtt{f}(\mathtt{V_{TL\#i-1}}) * \Delta\mathtt{M}] =$$

$$[\mathtt{M_i} - \mathtt{f}(\mathtt{V_{Mi}} - \mathtt{V_{TL\#i-1}}) * \Delta\mathtt{M}, \ \mathtt{M_i} + \mathtt{f}(\mathtt{V_{TL\#i}} - \mathtt{V_{Mi}}) * \Delta\mathtt{M}]$$

where $V_{Mi}$ is the value Vmeas such $M_i=f(V_{Mi})=f(V_{TL\#i}-1+a^*(V_{TL\#i}-V_{TL\#i-1}) \ a \in [0,1]$, wherein f is the tuning function.

In case a=0.5, $V_{Mi}$ is the middle point of the interval.

One aspect of the present invention relates to fine tuning. Determining the parameter value within said tuning range comprises identifying the nominal parameter value $M_i$ associated to the subrange $[V_{TL\#i-1} \ V_{TL\#i}]$ into which the quantized measured tuning variable $V_{meas}$ falls. This is a pre-stage to the further fine tuning which comprises mapping a difference $V_{meas}-V_{MI}$ between the quantized measured tuning variable $V_{meas}$ and a nominal tuning variable $V_{Mi}$ corresponding to the nominal parameter value $M_i$ in terms of the ADC resolution to a difference between the parameter value and the nominal parameter value in terms of a tuning range resolution $f(V_{meas}-V_{Mi})$ using the tuning function f(x); and setting the parameter value M to the sum of the nominal parameter value and the difference between the parameter value and the nominal parameter value in terms of the tuning range resolution times the tuning range resolution:

$$\mathtt{M=M_i+f(V_{meas}-V_{Mi}) * \Delta M.}$$

The parameter M may be a parameter of a power module and any of the following: output voltage set-point, threshold over-current shut-down, capacitance, inductance, switching frequency of a switching signal for switching a switched power stage.

Specifically, the determined parameter value M may be used to adjust a coefficient of a PID compensator controlling the electronic device such as a power module.

To summarize, the present invention provides a solution to solve the problem of fine tuning electronic device parameters by means of measuring a variable internal and external to the electronic device performing tuning around a build-in tuning function around a set of pre-configured nominal values. Resolution of the tuning method, e.g. resolution of a tuning range, can be programmed by a user in an internal memory of the electronic device. The range of tuning is determined as a function of the resolution of the tuning method and the build-in tuning function associated to the parameter to be tuned.

The present method can be used to tune any parameters of an electronic device such as a DC-DC converter such as, but not limited to, output voltage set-point, fault detection thresholds, i.e. over voltage / over current thresholds, parameters related to sequencing such as ramp up timings, ramp down timings and indirectly or directly compensator parameters, i.e. PID coefficients.

Nominal values of the parameter to be tuned form a set of discrete points of tuning function and tuning is performed around an identified nominal value following the mathematical law describing the tuning curve. The parameter to be tuned is tuned by means of measurement of an internal or external tuning variable containing information related to the tuning.

The nominal value of the tuning variable $V_{Mi}$ can be set arbitrarily such that it maps to the nominal parameter value using the configuration curve.

BRIEF DESCRIPTION OF THE DRAWINGS

Reference will be made to the accompanying drawings, wherein

Fig. 1     shows a graph of the tuning function;

Fig. 2     shows a tuning range of the tuning function with a nominal parameter value centered in the tuning range;

Fig. 3     shows a tuning range of the tuning function with a nominal parameter value not centered in the tuning range;

Fig. 4     shows a tuning range of the tuning function with a nominal parameter value set to the upper bound of the tuning range;

Fig. 5     shows a tuning range of the tuning function with a nominal parameter value set to the lower bound of the tuning range;

Fig. 6     shows a diagram showing pin-strapping by using a resistor;

Fig. 7     shows a diagram showing pin-strapping by using a potenziometer;

Fig. 8     shows a diagram showing pin-strapping by using a resistive network;

Fig. 9     shows a diagram showing pin-strapping by using a resistor;

Fig. 10     shows a diagram showing a dynamic range of an ADC being sub-divided into subranges;

Fig. 11     shows a diagram showing the tuning mechanism;

Fig. 12     shows a block diagram of buck converter;

Fig. 13     shows a block diagram of the tuning mechanism with respect to tuning of compensator parameters; and

Fig. 14     shows a frequency response of
a controller plant (top);
a whole DC-DC converter system in open loop (middle);
a compensator with parameters tuned according to the tuning mechanism to compensate for power stage poles variation (bottom).

DETAILED DESCRIPTION OF THE INVENTION

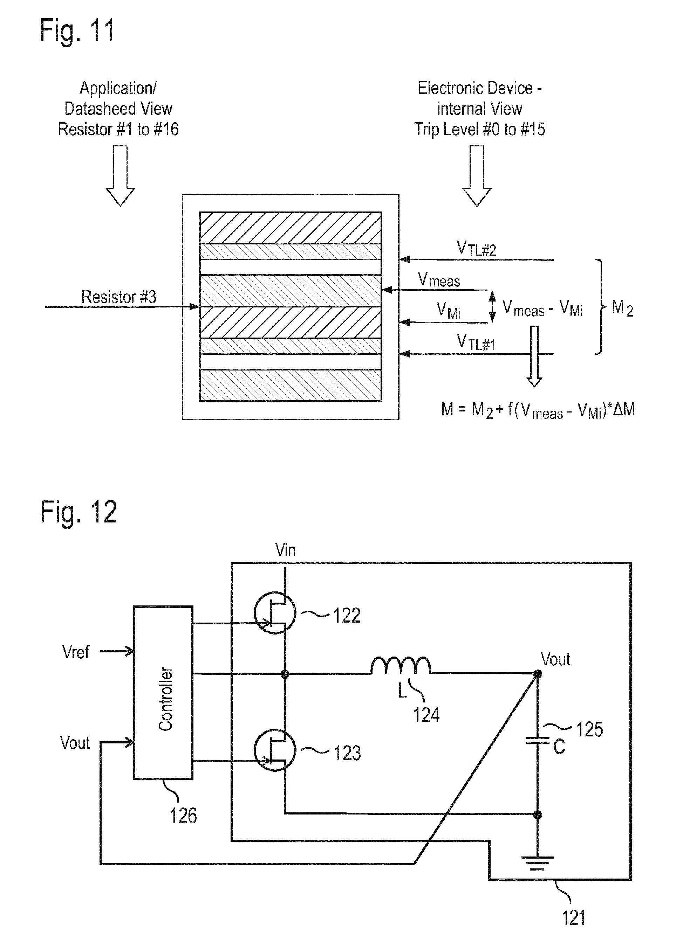

The tuning mechanism will be explained with reference to a buck converter as shown in Fig. 12. The buck converter comprises a switched power stage, wherein an output voltage is generated according to a switching signal and an input voltage. The switching signal is generated in a controller that adjusts the output voltage to a reference voltage. The switched power stage 121 comprises a dual switch consisting of a high-side switch 122 and a low-side switch 123, an inductor 124 and a capacitor 125. During a charge phase, the high-side switch 122 is turned on and the low-side switch 123 is turned off by the switching signal to charge the capacitor 125. During a discharge phase the high-side switch 122 is turned off and the low-side switch 123 is turned on to match the average inductor current to the load current. The controller comprises a compensator to compensate for the poles introduced by the inductance and capacitance of the output stage.

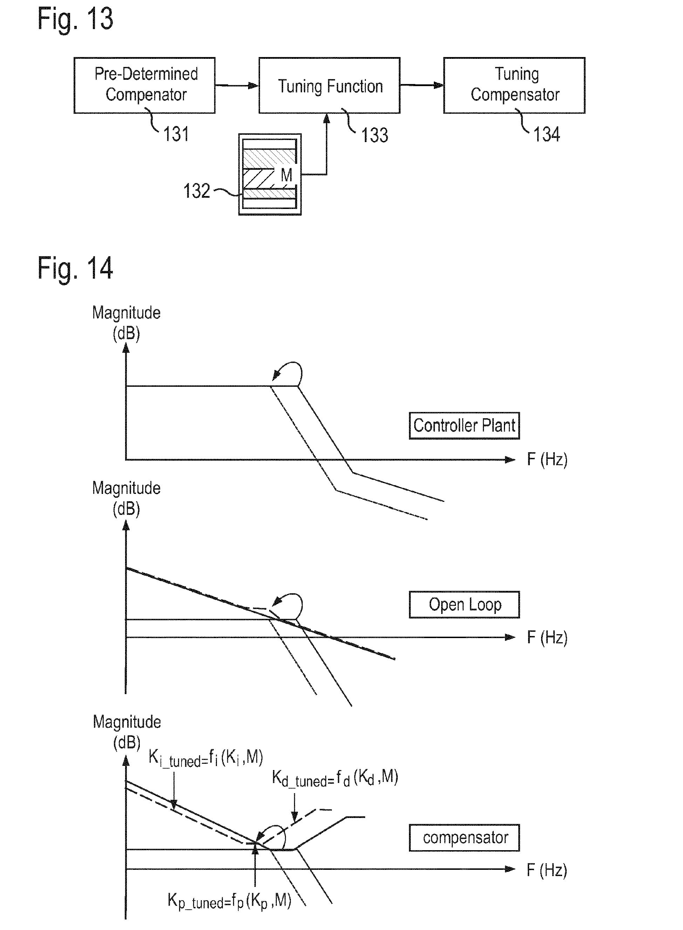

A block diagram of the tuning mechanism is shown in Fig. 13 wherein a pre-determined compensator 131 is tuned according to a tuning 133 to yield a tuned compensator 134. The tuning 133 modifies the compensator parameters according to parameter value M determined by the tuning mechanism 132.

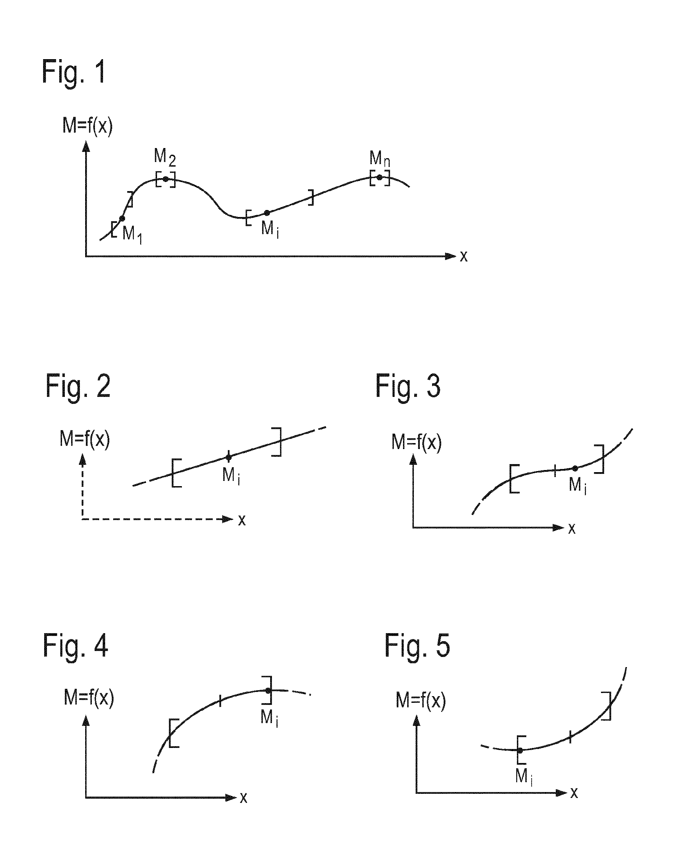

The tuning mechanism is based on pin-strapping and a tuning function f as shown in Fig. 1. The tuning function M=f(x) defines a set of possible values of the parameter M as a function of the tuning variable x. $M_i$ (i=1,..n) is a set of nominal parameter values of the curve M=f(x). Each nominal parameter value $M_i$ is associated with a respective tuning range bounded by a lower bound [and an upper bound]. Thus, the tuning function f(x) is a piece wise function comprising a plurality of tuning ranges and represents a tuning variable to parameter mapping. The tuning function can be linear as shown in Fig. 2 or non-linear but monotonic as shown in Fig. 3 -5.

The nominal parameter value may be placed arbitrarily within its respective tuning range as shown in Fig. 2 - Fig. 5. In Fig. 2 the nominal parameter value is centered in the tuning range. In Fig. 3 the nominal parameter value is not centered in the tuning range. In Fig. 4 the nominal parameter value is set to the upper boundary of the tuning range while in Fig. 5 the nominal parameter value is set to the lower boundary of the tuning range.

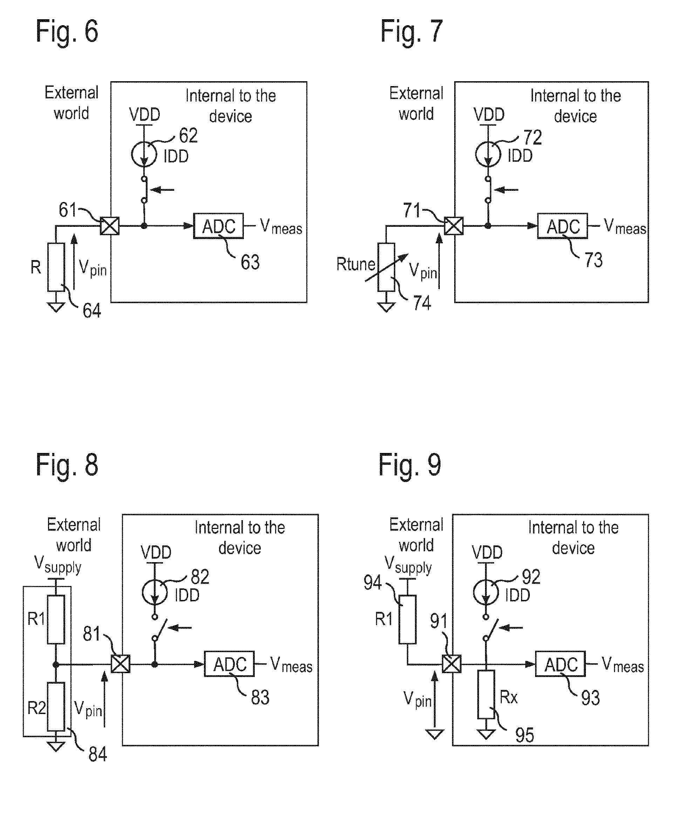

With pin-strapping, the tuning variable x is a voltage impinged upon a pin of the controller by a current flowing through an external resistive component placed to the pin as shown in Fig. 6 to 9.

Fig. 6 shows an embodiment wherein the voltage $V_{meas}$ impinged upon the pin 61 is generated by the flowing of a provided bias current through resistor 64 that is placed at the pin 61. The bias current is generated by current source 62 inside the controller of the buck converter. ADC 63 quantizes the voltage $V_{meas}$ which is the quantized tuning variable.

Fig. 7 shows another embodiment where the voltage $V_{meas}$ impinged upon the pin 71 is generated by the flowing of a provided bias current through a potentiometer 74 that is placed at the pin 74 and adjusted to achieve the desired value of the parameter M to be tuned. The bias current is generated by current source 72 inside the controller of the buck converter. ADC 73 quantizes the voltage $V_{meas}$ which is the quantized tuning variable.

Fig. 8 shows an alternative embodiment where the voltage at the pin 81 is generated by a network 84 of passive components R1 and R2 placed externally to the controller. The bias current is generated by current source 82 inside the controller of the buck converter. ADC 83 quantizes the voltage $V_{meas}$ which is the quantized tuning variable.

Fig. 9 still shows another embodiment where the voltage at the pin 91 is generated by a combination of a passive component 94 placed externally to the controller and a passive component 95 located internally to the controller. The bias current is generated by current source 92 inside the controller of the buck converter. ADC 93 quantizes the voltage $V_{meas}$ which is the quantized tuning variable.

Now returning to Fig. 6, in one embodiment a resistor 64 of the series E24 is used for pin-strapping. Taking into account resistor tolerances and additional errors deriving from the internal circuitry used to generate and measure the voltage $V_{pin}$, the dynamic range of the $N_{ADC}$ bits ADC 64 given by $[0, 2^{N_{ADC}}]$ is sub-divided into n subranges where each subrange is delimited by the ADC output codes $V_{TL\#i-1}$ and $V_{TL\#i}$. The number n of subranges is designed in a way that for a defined set of resistors with nominal values belonging to the E24 series, the nominal parameter values $M_i$ can be designed univocally.

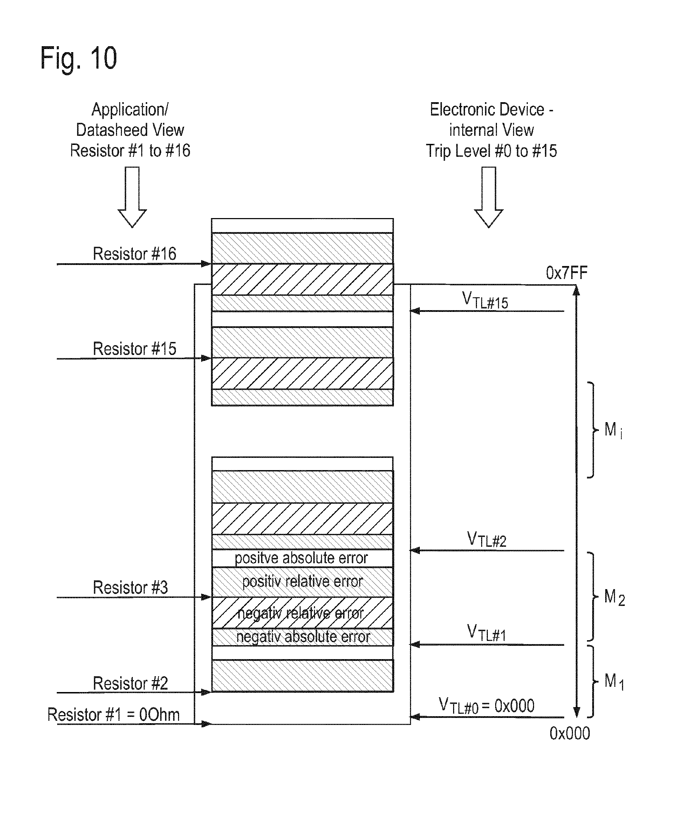

Fig. 10 shows an example of how the dynamic range of the ADC is divided into sub-ranges where each sub-range is associated to a measured voltage $V_{meas}$ at the pin with two trip levels $V_{TL}$. The number of sub-ranges in this example is n=16.

Assuming the resistor of value "Resistor#3" is placed at the pin of the circuit in Fig. 6, the nominal value $M_2$ is identified as the measured voltage $V_{meas}$ is located in the subrange bounded by $V_{TL\#1}$ and $V_{TL\#2}$ that is associated with $M_2$.

Fig. 11 shows the fine tuning according to the following formula $M=M_2+f(V_{meas}-V_{M2})*\Delta M$ for the following example: M2=4, a=0.5 (symmetrical tuning range), $\Delta M$=0.1, ADC resolution QADC=1.5mV, $V_{TL\#1}$=127 QADC = 190.5 mV, $V_{TL\#2}$ = 225 mV, $V_{Mi}=(V_{TL\#2}-V_{TL\#1}) *a*QADC=207.7$ mV, $V_{meas}$=137*QADC.

The tuning range is given by

$$[M_2-f(V_{TL\#2}-V_{TL\#1}) * \Delta M, \quad M_2+f(V_{TL\#2}-V_{TL\#1}) * \Delta M]=[2.85, \quad 5.15].$$

The value of the parameter M is computed to be

$$M=M_2+f\left(V_{meas}-V_{M2}\right)*\Delta M.$$

The difference $V_{meas}$-$V_{M2}$ in terms of the ADC resolution is 137-138.5 QADC. This difference is mapped in terms of the tuning resolution according to the function, then multiplied by the tuning resolution and finally added to the nominal parameter value $M_2$. Note, in this example the tuning function is a linear function that linearly maps the ADC resolution to the tuning range resolution.

By using the presented method, parameters of the compensator of a digital point of load (POL) DC-DC converter can be tuned to fit stability and transient requirements for different power stage scenarios. In this example, three different power stage scenarios are considered, where power stage scenarios differ for external component values, that is the inductance L of the inductor 124, the capacitance C of the capacitor 125 and the switching frequency Fsw of the switched power stage of the power module as shown in Fig. 12.

> Scenario 1: L=400nH, C=400uF (MLCC), Fsw=500kHz
> Scenario 2: L=400nH, C=330uF (OSCON), Fsw=500kHz
> Scenario 3: L=330nH, C=400uF (MLCC), Fsw=500kHz

Power stage scenarios 1, 2, 3 may represent three different power modules embedding the same POL DC-DC converter with LC output filter set at a minimum load capacitance C and equivalent series resistance (ESR) configuration.

Three different compensators may be designed to stabilize the power stage scenarios 1, 2, 3 by the use of a Graphical User Interface (GUI) and compensator parameters can be stored in an internal memory of the POL DC-DC converter.

In one embodiment the controller used is of the digital Proportional Integral Derivate (PID) controller type having parameters Ki, Kp, Kd being integral, proportional and derivative coefficients. For each of the power stage scenarios, a set of parameters Ki, Kp, Kd is memorized:

> Scenario 1: compensator C1: {Ki_C1, Kp_C1, Kd_C1}
>
> Scenario 2: compensator C2: {Ki_C2, Kp_C2, Kd_C2}
>
> Scenario 3: compensator C3: {Ki_C3, Kp_C3, Kd_C3}

Module makes may increase the amount of load capacitance placed at the output of the converter in order to meet application requirements such as transient performance. Varying parameters of the power stage, in this example the output capacitance (Ctot) alters the position of poles and zeros of the power stage leading to the need to tune zeros and poles of the pre-determined compensator Cj: {Ki_Cj, Kp_Cj, Kd_Cj}, j={1,2,3}. In this respect, compensator parameters Cj: {Ki_Cj, Kp_Cj, Kd_Cj} need to be tuned to maintain the system performance obtained for the minimum load capacitance case. Tuning of compensator parameters is done in operation by reading the value of the parameter M, set by module makers using the presented tuning method, and computing the new value of compensator parameters via a built-in compensator adjustment function. In this way, the compensation can be continuously tuned to suit various output capacitor values. Indeed, tuning of the parameters {Ki_Cj, Kp_Cj, Kd_Cj}, j={1,2,3} correspond to move in frequency position of zeros and poles of the compensator as shown in Fig. 14 bottom. The new set of compensator parameters, as a result of tuning, is expressed by

> Ki_Cj_tuned=fi(Ki_Cj,M)
> Kp_Cj_tuned=fp(Kp_Cj,M)
> Kd_Cj_tuned=fd(Kd_Cj,M)

where fi, fp and fd are the built-in compensator adjustment functions of the integral, proportional and derivative coefficients.

The advantages of the present invention are the following:

> Parameters of a pre-configured DC-DC converter can be fine-tuned around a set of pre-programmed nominal values without the need to fully reconfigure the device.

Fine-tuning of parameters can be done using inaccurate external components.

The resolution of the tuning method is programmable and can be stored among configuration data of the DC-DC converter. Built-in adjustment function allows tuning of parameters according to linear and non-linear laws.

Although pre-configured values of the variable to tune may be located on a non-linear curve, the proposed method allows linearization of the tuning function around the pre-configured nominal values of the variable to be tuned.

In case the resolution of the tuning method $\Delta M$ is set to 0, the values that the parameter to tune assumes are the pre-configured nominal values.

## Claims

1. Method for tuning a parameter of an electronic device, said method comprising:

   measuring a tuning variable;
   translating said measured tuning variable into a tuning range out of a plurality of tuning ranges representing a piece-wise tuning function, wherein the piece-wise tuning function represents a tuning variable to parameter value mapping; and wherein each tuning range is associated with a nominal parameter value;
   determining a parameter value within said tuning range; and
   setting the parameter to the determined parameter value.

2. Method according to claim 1, wherein measuring the tuning variable comprises quantizing a measured tuning variable using an analog-to-digital converter (ADC) having an ADC resolution; wherein a dynamic range of the ADC is subdivided into a plurality of sub-ranges, each sub-range being associated with a respective nominal parameter value and being bounded by its upper bound and by its lower bound.

3. Method according to claim 2, wherein the tuning variable to parameter mapping comprises
   a mapping of a nominal value of the tuning variable to the nominal parameter value and
   a mapping of a subrange to a tuning range comprising a mapping of an ADC resolution to a tuning range resolution.

4. Method according to claim 3 further comprising:

   defining a tuning range by
   setting an arbitrary value of the tuning variable within a subrange corresponding to the tuning range to a nominal value of the tuning variable such that it maps to the nominal parameter value using the tuning function; and
   setting the tuning resolution.

5. Method according to claim 4, wherein setting an arbitrary value of the tuning variable with a subrange to a nominal value of the tuning variable comprises setting the nominal value in the middle of a subrange such that it maps to a nominal parameter value in the middle of a tuning range.

6. Method according to claim 2, wherein determining the parameter value within said tuning range comprises:

   identifying the nominal parameter value associated to the subrange into which the quantized measured tuning variable falls; and
   mapping a difference between the quantized measured tuning variable and a nominal tuning variable corresponding to the nominal parameter value in terms of the ADC resolution to a difference between the parameter value and the nominal parameter value in terms of a tuning range resolution using the tuning function; and
   setting the parameter value to the sum of the nominal parameter value and the difference between the parameter value and the nominal parameter value in terms of the tuning range resolution times the tuning range resolution.

7. Method according to claim 3 to 4 wherein the tuning function and/or the tuning resolution is programmable in non-volatile memory.

8. Method according to any of claims 1 to 7 further comprising:

   using the determined parameter value to adjust a coefficient of a PID compensator controlling the electronic device.

9. Method according to any of claims 1 to 8, wherein the tuning variable is an actual input voltage impinged upon a pin of the electronic device.

10. Method according to claim 9, wherein the actual input voltage at the pin is generated by a flowing of a provided bias current through a tuning resistor.

11. Method according to claim 9, wherein the actual input voltage at the pin is generated by a flowing of a provided bias current through a potentiometer that is adjusted to achieve a desired value of the parameter to be tuned.

12. Method according to claim 9, wherein the actual input voltage is generated by a flowing of a provided bias current through a network of passive components placed externally to the electronic device.

13. Method according to claim 9, wherein the actual input voltage is generated by a flowing of a provided bias current through a network of passive components placed externally to the electronic device and a passive component located internally to the device.

14. Method according to any of claims 10 to 13, wherein the provided bias current is generated internally to the electronic device.

15. Method according to any of claims 1 to 14, wherein the electronic device is a power module and the parameter is any of the following:

output voltage set-point, threshold over-current shut-down, capacitance, inductance, switching frequency of a switching signal for switching a switched power stage.

Fig. 1

Fig. 2

Fig. 3

Fig. 4

Fig. 5

# Fig. 6

# Fig. 7

# Fig. 8

# Fig. 9

## Fig. 10

Application/
Datasheed View
Resistor #1 to #16

Electronic Device -
internal View
Trip Level #0 to #15

Resistor #16

Resistor #15

0x7FF

$V_{TL\#15}$

$M_i$

Resistor #3

positve absolute error
positiv relative error
negativ relative error
negativ absolute error

$V_{TL\#2}$

$V_{TL\#1}$

$M_2$

Resistor #2

$M_1$

Resistor #1 = 0Ohm

$V_{TL\#0} = 0x000$

0x000

## Fig. 11

Application/
Datasheed View
Resistor #1 to #16

Electronic Device -
internal View
Trip Level #0 to #15

Resistor #3

$V_{TL\#2}$

$V_{meas}$

$V_{Mi}$

$V_{meas} - V_{Mi}$

$V_{TL\#1}$

$M_2$

$M = M_2 + f(V_{meas} - V_{Mi})*\Delta M$

## Fig. 12

Vin

Vref

Vout

Controller

126

122

123

L

124

Vout

125

C

121

Fig. 13

```
┌──────────────────┐     ┌──────────────────┐     ┌──────────────────┐
│  Pre-Determined  │────▶│  Tuning Function │────▶│     Tuning       │
│   Compenator     │     │                  │     │   Compensator    │
└──────────────────┘     └──────────────────┘     └──────────────────┘
        131                     133                       134
```

Fig. 14

Magnitude (dB)

Controller Plant

F (Hz)

Magnitude (dB)

Open Loop

F (Hz)

Magnitude (dB)

$K_{i\_tuned}=f_i(K_i,M)$

$K_{d\_tuned}=f_d(K_d,M)$

compensator

$K_{p\_tuned}=f_p(K_p,M)$

F (Hz)

Europäisches
Patentamt

European
Patent Office

Office européen
des brevets

# EUROPEAN SEARCH REPORT

Application Number

EP 15 16 7853

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | US 2010/207594 A1 (DAVOUDI ALI [US] ET AL) 19 August 2010 (2010-08-19) * paragraphs [0003], [0041], [0042], [0046], [0048] - [0050], [0071]; figures 5,6 * | 1-15 | INV. H02M3/156 H02M3/157 |

TECHNICAL FIELDS
SEARCHED      (IPC)

H02M

The present search report has been drawn up for all claims

| Place of search | Date of completion of the search | Examiner |
|---|---|---|
| The Hague | 21 October 2015 | Taccoen, J |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

**EP 3 093 968 A1**

## ANNEX TO THE EUROPEAN SEARCH REPORT
## ON EUROPEAN PATENT APPLICATION NO.

EP 15 16 7853

This annex lists the patent family members relating to the patent documents cited in the above-mentioned European search report.
The members are as contained in the European Patent Office EDP file on
The European Patent Office is in no way liable for these particulars which are merely given for the purpose of information.

21-10-2015

| Patent document cited in search report | Publication date | Patent family member(s) | Publication date |
|---|---|---|---|
| US 2010207594 A1 | 19-08-2010 | NONE | |

For more details about this annex : see Official Journal of the European Patent Office, No. 12/82

**REFERENCES CITED IN THE DESCRIPTION**

**Patent documents cited in the description**

- US 4349777 A
- US 7292019 B1